# EUROPEAN PATENT APPLICATION

(11) **EP 1 791 028 A1**
(43) Date of publication of application: **30.05.2007**
(21) Application number: 05780882.6
(22) Date of filing: 23.08.2005
(51) Int. Cl.: G03F 7/40, H01L 21/027

(54) **MICRO PATTERN FORMING MATERIAL, METHOD OF FORMING MICRO RESIST PATTERN AND ELECTRONIC DEVICE**

(30) Priority: 25.08.2004 JP 2004245333
(71) Applicant: Renesas Technology Corp., Tokyo 100-6334 (JP); AZ Electronic Materials (Japan) K.K., Tokyo 113-0021 (JP)
(72) Inventor: ISHIBASHI, Takeo c/o Renesas Technology Corp., Chiyoda-ku Tokyo 1006334 (JP); TAKAHASHI, K. AZ Electronic Materials(Japan)K.K., Kakegawa-shi Shizuoka 4371412 (JP); TAKANO, Yusuke AZ Electronic Materials(Japan)K.K., Kakegawa-shi Shizuoka 4371412 (JP)
(74) Representative: Neidl-Stippler, Cornelia
(86) International application number: PCT/JP2005/015249
(87) International publication number: WO 2006/022246

(57) **Abstract**

A fine pattern forming material comprising a water soluble resin of polyvinyl alcohol derivative, etc., a water soluble crosslinking agent of melamine derivative, urea derivative, etc., an amine compound, a nonionic surfactant and water or a solution of a mixture of water and water soluble organic solvent, the solution exhibiting a pH value of >7. This fine pattern forming material is applied onto resist pattern (3) to thereby form coating layer (4), and the coating layer (4) is heated and developed to thereby form crosslinked coating layer (5). The thickness of the crosslinked coating layer is increased by the use of a secondary amine compound and/or tertiary amine compound over that realized when no amine compound is added, while the thickness of the crosslinked coating layer is decreased by the use of a quaternary amine.

## Description

### Technical Field

The present invention relates to a fine pattern forming material used upon forming a resist pattern in a process of manufacturing an electronic device or the like, wherein the fine pattern forming material is applied onto a previously formed resist pattern and the width of a gap between previously formed resist patterns or the size of a pattern opening is reduced, and a method of forming a fine resist pattern using the fine pattern forming material. More specifically, the present invention relates to a fine pattern forming material used in the pattern forming method, which can be allowed to increase the thickness of a crosslinked coating layer on the resist pattern without increasing the amount of a crosslinking agent to be added to the fine pattern forming material and without raising the reaction temperature upon a crosslinking reaction, or to decrease the thickness of the crosslinked coating layer on the resist pattern without decreasing the amount of the crosslinking agent to be added to the fine pattern forming material and without lowering the crosslinking reaction temperature and a method of forming a fine resist pattern using the fine pattern formingmaterial. The present invention also relates to an electronic device manufactured by utilization of the fine pattern forming method.

### Background Art

In various fields including manufacturing electronic devices, for example, semiconductor elements such as LSIs, fabricating liquid crystal display faces of LCD panels, manufacturing circuit boards such as thermal heads, and the like, the formation of resist patterns on a substrate is conducted for the formation of a fine element or fine processing. The formation of these resist patterns employs so-called photolithography that involves light exposure of a photosensitive resin composition by selective irradiation with actinic rays such as ultraviolet rays, deep ultraviolet rays, an excimer laser, X-rays or electron beams and the subsequent development treatment thereof. In this photolithographic method, a positive- or negative-working photosensitive resin composition is used to form resist patterns. With recent high integration of semiconductor devices and the like, the line width of a wire and a distance between wires required in the manufacturing process of the device come to be further fine. To cope with the situations, a light-exposure apparatus utilizing a short-wavelength light source such as a g-line, an i-line and an excimer laser is used, and a phase-shift mask or the like is also used in the light exposure. In the conventional photolithographic technology using light exposure, however, the formation of fine resist patterns exceeding the limit of wavelength is difficult, and the light-exposure devices for short wavelength and the devices using a phase-shift mask are expensive. Accordingly, methods wherein resist patterns are formed from a known positive- or negative-working photosensitive resin composition by a known pattern-forming device without using the expensive devices and the formed resist patterns are effectively made fine, have been extensively studied and reported (for example, see Patent Documents 1 to 4 below). The method of making a resist pattern effectively fine involves the steps of forming a pattern using a conventionally known photoresist by means of a conventional method, forming a coating layer of a fine pattern forming material onto the formed resist pattern, diffusing an acid generated in the resist or contained in the resist into the coating layer by heating and/or exposure of the resist, crosslinking and curing the coating layer with the diffused acid, removing a non-crosslinked coating layer to thicken the resist pattern, thereby decreasing the separation width of the resist patterns, reducing the separation size or hole opening size of the resist pattern to miniaturize the resist pattern , and thus effectively forming a fine resist pattern having a resolution limit or smaller. In addition, a method is also known that involves the steps of forming a coating layer comprising a water soluble resin and water soluble amine, heating the coating layer to shrink photoresist pattern intervals, and then completely removing the water soluble resin to forma fine resist pattern (for example, see Patent Document 5 below).

Patent Document 1: Japanese Patent Application Laid-Open No.Hei-5-241348 (JP-A-Hei-5-241348)

Patent Document 2: JP-A-Hei-6-250379

Patent Document 3: JP-A-Hei-10-73927

Patent Document 4: JP-A-Hei-11-204399

Patent Document 5: JP-A-2003-107752

Incidentally, in the above-described method of forming a crosslinkable coating layer on a resist pattern and then crosslinking the coating layer to thicken the resist pattern and in consequence to decrease the separation size of hole opening size of the pattern, a method is so far employed that involves increasing the amount of a crosslinking agent relating to the crosslinking reaction or increasing the reaction temperature during the crosslinking reaction, when the crosslinked layer of a coating layer is thickened more greatly, whereby the separation size or hole opening size of the pattern is made more decreased. However, in the case where a water soluble resin and water soluble crosslinking agent are selected as main components of the aforementioned fine pattern forming materials and these components are dissolved in water or a mixture liquid of water and a water soluble organic solvent to form a fine pattern forming material for use, there is a problem that the stability with time of the fine pattern forming material extremely deteriorates when the amount of a water soluble crosslinking agent is increased. On the other hand, when the crosslinking reaction temperature is increased, it is confirmed that the number of defects after development tends to increase. Because of this, when a fine pattern forming material as described above is used, a method of increasing the amount of the crosslinking agent and a method of increasing the crosslinking reaction temperature are presently difficult to adopt as means for increasing the thickness of the crosslinked coating layer. Further, recently a demand for decreasing in the thickness of the crosslinked coating layer is sometimes required. For this demand, an execution is employed at present that entails decreasing the amount of a water soluble crosslinking agent added to a fine pattern forming material or decreasing the crosslinking reaction temperature. However, in the case where such an operation is carried out, a problem of very frequently causing development defects due to a decrease in crosslinking density upon the crosslinking layer formation is caused.

In addition, as fine pattern forming materials, there has been reported a fine pattern forming material composition prepared by adjusting the pH value of a fine pattern forming material composition comprising a mixture of a water soluble resin, a water soluble crosslinking agent and water or a mixture solvent of water and a water soluble organic solvent to 4.0 to 7.0 through the use of a water soluble basic compound such as an amine compound (see Patent Document 6 below) . However, in this fine pattern forming material composition, there is a problem in application properties when the solvent is only water. Moreover, the addition of a surfactant for an improvement in application properties thereof leads to a tendency of remarkable foaming due to the surface active effect of the surfactant, whereby it is difficult to use surfactants as a fine pattern forming material.

Patent Document 6: JP-A-2002-60641

Considering these situations, an object of the present invention is to provide a fine pattern forming material that can control the thickness of a crosslinked coating layer without increasing or decreasing the amount of a water soluble crosslinking agent in the fine pattern forming material and without increasing or decreasing the crosslinking reaction temperature and that can restrain the foaming when a surfactant is added to improve application properties; a method of forming a resist pattern by use of the fine pattern forming material; and an electronic device manufactured by utilizing the resist pattern forming method.

### Disclosure of the Invention

### Means for Solving the Problems

As a result of intensive studies and investigations, the present inventors found that the aforementioned object can be attained by containing an amine compound in a fine pattern forming material comprising a mixture of a water soluble resin of a polyvinyl alcohol derivative, etc., a water soluble crosslinking agent of a melamine derivative, a urea derivative, etc., and water or a mixture liquid of water and a water soluble organic solvent as a solvent, and by adjusting the pH value of the resulting solution to a specified value. The present invention was completed based on the findings.

That is, the present invention relates to a fine pattern forming material that is applied onto a resist pattern to cause a crosslinking reaction by heat treatment and then subj ected to development processing to forma crosslinked coating layer on the aforementioned resist pattern, wherein the material is characterized in that water or a mixture liquid of water and a water soluble organic solvent is used as a solvent, the fine pattern forming material is formed by adding a water soluble resin, a water soluble crosslinking agent and an amine compound into the solvent, an increase or decrease in the thickness of the crosslinked coating layer, thereby, can be controlled as compared with a crosslinked coating layer formed by use of a fine pattern forming material prior to the addition of the amine compound, and a pH value of the resulting solution exceeds 7.

Further, the present invention relates to a fine pattern forming material that is applied onto a resist pattern, causes a crosslinking reaction by heat treatment, and then subj ected to development processing to forma crosslinked coating layer on the aforementioned resist pattern, wherein the material is characterized in that water or a mixture liquid of water and a water soluble organic solvent is used as a solvent, the fine pattern forming material is formed by adding a water soluble resin, a water soluble crosslinking agent and a secondary amine compound and/or tertiary amine compound into the solvent, a thickness of the crosslinked coating layer, thereby, increases as compared with a crosslinked coating layer formed by use of a fine pattern forming material prior to the addition of the amine compound, and a pH value of the resulting solution exceeds 7.

Furthermore, the present invention relates to the above-described fine pattern forming material characterized in that the secondary amine compound is a compound selected from dimethylamine, diethylamine, dimethanolamine and diethanolamine, and the tertiary amine compound is a compound selected from trimethylamine, triethylamine, trimethanolamine and triethanolamine.

Further, the present invention relates to a fine pattern forming material that is applied onto a resist pattern, causes a crosslinking reaction by heat treatment, and then subjected to development processing to form a crosslinked coating layer on the aforementioned resist pattern, wherein the material is characterized in that water or a mixture liquid of water and a water soluble organic solvent is used as a solvent, the fine pattern forming material is formed by adding a water soluble resin, awater soluble crosslinking agent and a quaternary amine compound into the solvent, a thickness of the crosslinked coating layer, thereby, decreases as compared with a crosslinked coating layer formed by use of a fine pattern forming material prior to the addition of the amine compound, and a pH value of the resulting solution exceeds 7.

Further, the present invention relates to the above-described fine pattern forming material characterized in that the quaternary amine compound is a compound selected from tetramethylammonium hydroxide, tetraethylammonium hydroxide, tetramethylammonium chloride, and tetraethylammonium chloride.

Further, the present invention relates to any one of the fine pattern forming materials described above, characterized in that the water soluble resin is a polyvinyl alcohol derivative, and the water soluble crosslinking agent is at least one selected from the group consisting of melamine derivatives and urea derivatives.

Further, the present invention relates to the above-described fine pattern forming material characterized in that the polyvinyl alcohol derivative does not contain therein a vinyl acetate residue causing a deacetylation reaction.

Further, the present invention relates to the above-described fine pattern forming material characterized by further comprising a nonionic surfactant, and thereby improving the application properties.

Further, the present invention relates to the above-described fine pattern forming material characterized in that the nonionic surfactant is at least one selected from polyoxyethyleneoctyl ether, polyoxyethylenelauryl ether and polyoxyethyleneacetylenic glycol ether.

Furthermore, the present invention relates to a method of forming a fine resist pattern, characterized by comprising the steps of applying a photoresist on a substrate and then forming a photoresist pattern, applying any one of the above-described fine pattern forming materials onto the formed photoresist pattern to form a coating layer, baking the photoresist pattern and the coating layer, and developing the coating layer.

Further, the present invention relates to an electronic device characterized by being manufactured by utilizing the method of forming a fine resist pattern described above.

### Brief Description of the Drawings

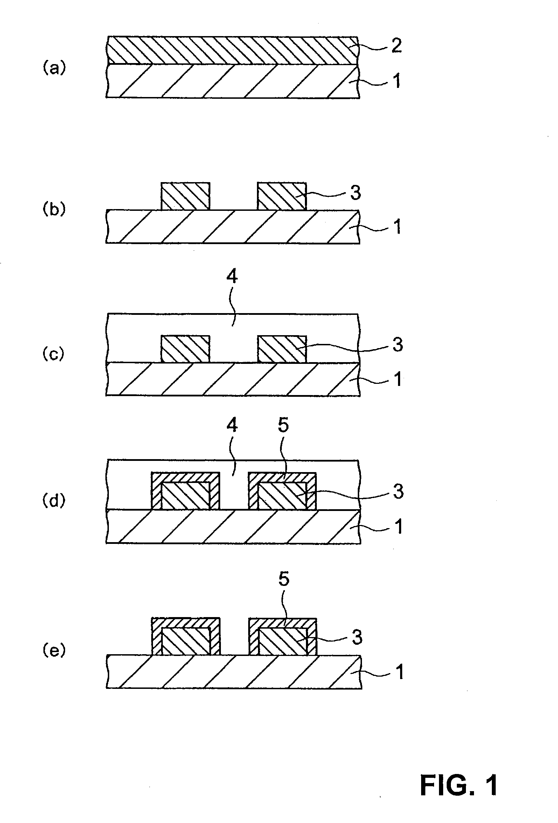

FIG. 1 is a schematic view showing steps of thickening a resist pattern by using a fine pattern forming material to thereby narrow the size between resist patterns, and forming a resist pattern having a pattern gap width of a resolution limit or smaller. In FIG. 1, reference numeral 1 denotes a substrate, 2 denotes a photoresist film, 3 denotes a resist pattern, 4 denotes a coating layer made of a fine pattern forming material, and 5 denotes a crosslinked coating layer insoluble in a developing solution.

### Detailed Description of the Invention

The present invention will be described in more detail hereinafter.

The present invention provides a fine pattern forming material that is produced by improving a conventionally known fine pattern forming material comprising a mixture of a water soluble resin, a water soluble crosslinking agent, and, as a solvent, water or a mixture liquid of water and a water soluble organic solvent. The fine pattern forming material of the invention can be controlled in the thickness of a crosslinked coating layer without affecting the stability with time and without increasing or decreasing the heating temperature, and also is improved in application properties. Therefore, a water soluble resin, a water soluble crosslinking agent, water and a water soluble organic solvent constituting the fine pattern forming material of the present invention can utilize any of conventionally known materials that constitute the fine pattern forming material.

That is, examples of the water soluble resin include polyvinyl alcohol derivatives including polyvinyl alcohol, polyacrylic acid, polyvinyl pyrolidone, polyethyleneimine, polyethylene oxide, poly(styrene-maleic anhydride) copolymers, polyvinyl amines, water soluble resins containing an oxazoline group, water soluble melamine resins, water soluble urea resins, water soluble alkyd resins, polysulfone amides, and salts thereof. These water soluble resins may be used alone or in combination with two or more thereof. Of these water soluble resins, polyvinyl alcohol derivatives are preferred. Examples of these polyvinyl alcohol derivatives include polyvinyl alcohol, polyvinyl formal, polyvinyl acetal, polyvinyl butyral, and the like. A water soluble polyvinyl alcohol is normally manufactured by partially or completely saponifying polyvinyl acetate. Polyvinyl alcohol derivatives used in the invention may be, as long as it is water soluble, any of such conventionally known water soluble polyvinyl alcohol derivatives, i.e., partially or completely saponified polyvinyl alcohol derivatives. The above-described polyvinyl formal, polyvinyl acetal, polyvinyl butyral, and the like may also be ones manufactured by formalization, acetalization, butyralization, and the like of the partially or completely saponified polyvinyl alcohol. Any of polyvinyl formal, polyvinyl acetal and polyvinyl butyral is preferred as polyvinyl alcohol derivatives that are water soluble resins of the present invention. However, as the partially saponified polyvinyl alcohol derivative contains an acetyl group, etc., when the derivative is mixed with an amine compound, it is thought that a saponification reaction may be caused to eliminate acetyl groups according to circumstances. In contrast to this, polyvinyl formal, polyvinyl acetal, polyvinyl butyral, and the like manufactured by use of completely saponified polyvinyl alcohol have no danger of the above-described saponification reaction, and so do not cause the problem of changes with time seen in partially saponified chemicals. Hence, from the viewpoint of the stability with time of a fine pattern forming material, it is preferred that a polyvinyl alcohol derivative does not contain a vinyl acetate residue causing deacetylation. And with the range of not hindering the effect of the present invention, a water soluble resin conventionally known as a resin for the fine pattern formation can also be used together with the water soluble polyvinyl alcohol derivative.

Further, as a water soluble crosslinking agent, any one of them can be used as long as it crosslinks and cures a water soluble resin with an acid to form a film insoluble in a developing agent in the present invention. Examples of these water soluble crosslinking agents include melamine derivatives, urea derivatives, guanamine derivatives, glycoluril, and alkoxy alkylated amino resins. Of these water soluble crosslinking agents, examples of the melamine derivatives include melamine, methoxy methylated melamine, methoxy ethylated melamine, propoxy methylated melamine, and hexamethylol melamine. Examples of the urea derivatives include urea, monomethylol urea, dimethylol urea, alkoxymethylene urea, N-alkoxymethylene urea, ethylene urea, and ethylene urea carboxylic acids. Examples of the guanamine derivatives include acetoguanamine, benzoguanamine, and methylated benzoguanamine. Examples of the alkoxy alkylated amine resins include alkoxy alkylated melamine resins, alkoxy alkylated benzoguanamine resins, and alkoxy alkylated urea resins. Specifically, the examples of the alkoxy alkylated amine resins include methoxy methylated melamine resins, ethoxymethylated melamine resins, propoxymethylatedmelamine resins, butoxy methylated melamine resins, ethoxy methylated benzoguanamine resins, methoxy methylated urea resins, ethoxy methylated urea resins, propoxy methylated urea resins, and butoxy methylated urea resins. As water soluble crosslinking agents, melamine derivatives and urea derivatives are particularly preferred. These water soluble crosslinking agents may also be used alone or in combination with two or more thereof. The compounding amount of the water soluble crosslinking agent is from 5 to 60 weight parts, preferably from 10 to 30 weight parts, based on 100 weight parts of a water soluble resin. Water soluble crosslinking agents preferably used in the invention are melamine derivatives and urea derivatives.

In the invention, water or a mixture liquid of water and a water soluble organic solvent is used as a solvent. Water used as a solvent is not particularly limited as long as it is water. And water from which organic impurities and metal ions are removed by distillation, ion exchange treatment, filter treatment, treatment with various adsorbing agents, or the like, for example, purified water is preferred. On the other hand, a water soluble organic solvent is not particularly limited as long as it can be soluble in water in a ratio of 0.1 weight-% or more relative to water. The examples of the water soluble organic solvents may include alcohols such as methyl alcohol, ethyl alcohol, n-propyl alcohol, and isopropyl alcohol (IPA) ; ketones such as acetone and methyl ethyl ketone; esters such as methyl acetate and ethyl acetate; ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactate esters such as methyl lactate and ethyl lactate; aromatic hydrocarbons such as toluene and xylene, amides such as N,N-dimethylacetoamide and N-methyl pyrrolidone; lactones such as γ-butyrolactone; and non-protic polar solvents such as N,N-dimethylformamide and dimethylsulfoxide, and of these, C₁ to C₄ lower alcohols such as methyl alcohol, ethyl alcohol, n-propyl alcohol, isopropyl alcohol, and isobutanol; and non-protic polar solvents such as N, N-dimethylformamide and dimethylsulfoxide are preferred. These solvents can be used alone or in a mixture of two or more thereof. The amount of these solvents in the water soluble resin composition is made within the range of not dissolving a resist pattern thereby when added. Solvents used in the invention preferably include a water soluble organic solvent in order to restrain foaming when a surfactant is added thereto.

Furthermore, amine compounds are used in the fine pattern forming material of the invention. When a secondary amine compound or tertiary amine compound is added to a fine pattern forming material as the amine compound, the crosslinking reaction is promoted and a thicker crosslinked film of the coating layer can be formed by heating under conditions similar to conventional heating conditions. On the other hand, when a quaternary amine compound is added to a fine pattern forming material, the crosslinking reaction is restrained and a thinner crosslinked film of the coating layer can be formed by heating under conditions similar to conventional heating conditions.

Examples of the above-described secondary amine compounds featured in the fine pattern forming material of the invention include dialkylamines such as dimethylamine and diethylamine; dialcoholamines such as dimethanolamine and diethanolamine; and polymers containing an amine. Further, examples of the tertiary amine compounds include trialkylamines such as trimethylamine and triethylamine; and trialcoholamines such as trimethanolamine and triethanolamine. These secondary amine compounds and tertiary amine compounds can be used alone or in combination with two or more thereof. In the invention, it is needed that the compounding amount of the secondary amine compound or tertiary amine compound is a sufficient amount that allows a pH value of the fine pattern forming material to exceed 7. The compounding amount of the secondary amine compound or tertiary amine compound varies depending on the kind of a water soluble resin or water soluble crosslinking agent for use, but is normally from 0. 5 to 15 weight parts, preferably from 2 to 8 weight parts, based on 100 weight parts of a water soluble resin.

Examples of the above-described quaternary amine compounds include ammonium hydroxides such as tetramethylammonium hydroxide and tetraethylammonium hydroxide; and ammonium chlorides such as tetramethylammonium chloride and tetraethylammonium chloride. These quaternary amine compounds can be used alone or in combination with two or more thereof. And it is also needed that the compounding amount of the quaternary amine compound is a sufficient amount that allows a pH value of the fine pattern forming material to exceed 7. The compounding amount of the quaternary amine compound varies depending on the kind of a water soluble resin or water soluble crosslinking agent, but is normally from 0.5 to 15 weight parts, preferably from 2 to 8 weight parts , based on 100 weight parts of a water soluble resin.

Further, a nonionic surfactant is added to the fine pattern forming material of the invention in order to improve application properties of the fine pattern forming material. The nonionic surfactants used for realizing this purpose include nonionic surfactantssuch aspolyoxyethyleneoctyl ether, polyoxyethylenelauryl ether,polyoxyethylene acetylenic glycolether,and the like. Examples of these nonionic surfactants include Acetyrenols available from Kawaken Fine Chemicals Co., Ltd., Surfynols available from Nissin Chemical Industry Co., Ltd., and Pionin available from Takemoto Oil & Fat Co., Ltd. These nonionic surfactants can be used alone or in combination with two or more thereof. The compounding amount of the nonionic surfactant is, for example, from 0.1 to 5 weight parts, preferably from 0.5 to 3 weight parts, based on 100 weight parts of a water soluble resin. And in the fine pattern forming material of the invention, a thicker crosslinked coating film is formed by the addition of the nonionic surfactant than the case where no nonionic surfactant is added.

The fine pattern forming material of the invention desirably contains therein from 1 to 30 weight parts of a water soluble resin, from 0.1 to 10 weight parts of a water soluble crosslinking agent and from 0.1 to 5 weight parts of an amine compound, based on 100 weight parts of water or a mixture solvent of water and a water soluble organic solvent. In the invention, the solvent is preferably a mixture solvent of water and a water soluble organic solvent. The compounding amount of a water soluble organic solvent is desirably from 2 to 10 weight parts based on 100 weight parts of water in order not to increase the amount of fine particles of the water soluble crosslinking agent in the liquid and furthermore in order to restrain foaming when a nonionic surfactant is added.

In the invention, use of the above-described fine pattern forming material of the invention enables the formation of a thickened resist pattern. The formation of a thickened resist pattern by the present invention may be carried by a method of applying the fine pattern forming material of the invention onto a resist pattern formed by a conventional method to thereby form a coating layer, baking the resist pattern and the coating layer to be allowed to diffuse an acid from the resist pattern into the coating layer, and then developing the thus-obtained crosslinked coating layer. This method is a conventionally known or well-known method except that a fine pattern forming material to be used is different. The resist pattern may be constituted by any one of materials from which an acid can be diffused into the coating layer by heating. Accordingly, a photosensitive resin composition forming a resist pattern is not particularly limited, but a chemically amplified photosensitive resin composition is preferred. The fine pattern forming method of the invention by which a thickened resist pattern is formed by use of, for example, the chemically amplified photosensitive resin composition will be specifically explained hereinafter by referring to FIG. 1.

That is, a chemically amplified positive-working radiation-sensitive resin composition is applied onto a substrate **1** of bare silicon or silicon having a metal oxide film such as a silicon oxide film or a metal film of aluminum, molybdenum, chromium or the like, or a metal oxide film such as ITO on the surface thereof, if necessary, by means of a known method such as a spin coating method, a roll coating method, a land coating method, a flowing and spreading coating method, or a dip coating method to form a thin photoresist film. Then, the thin photoresist film is pre-baked at 70 to 150°C for about one minute, as required, to form a photoresist film **2** on the substrate **1** as shown in FIG. 1(a). Thereafter, pattern exposure to the photoresist film is carried out through an exposure mask (not shown) such as a reticle, and then a post-exposure bake (PEB) is carried out, for example, at 50 to 150°C, as required. The film is developed using a developer for exclusive use, and then a bake after development is performed, as required, at 60 to 120°C to form a resist pattern **3** on the substrate **1,** as shown in FIG. 1(b). Examples of light-exposure sources to be used upon the pattern exposure include, for example, deep ultraviolet rays such as a KrF excimer laser and an ArF excimer laser, X-rays, and electron beams. Further, the developer to be used may be any one as long as it can develop a chemically amplified positive-working radiation sensitive resin composition to be used, and as the developer, an alkaline solution of, for example, tetramethylammonium hydroxide, sodium hydroxide or the like can be used. Furthermore, the developing method may be any one so far applied for developing a photoresist such as a paddle method or a spray method.

Onto the above-described resist pattern **3** a fine pattern forming material of the invention is applied, and the resulting product is baked, as required, for example, at 65 to 85°C for about one minute to form a coating layer **4** on the resist pattern **3** as shown in FIG. 1(c). Then, a bake is carried out, for example, at a baking temperature of 90 to 140°C, preferably about 100 to about 130°C for about one minute in order to diffuse an acid from the resist pattern **3** into the coating layer **4.** Thereby the acid is diffused from the resist pattern **3** to form a crosslinked coating layer **5** in the coating layer **4** as indicated in FIG. 1(d). The coating layer **4** is developed with a developer for exclusive use and the coated layer which is not crosslinked is removed to form a pattern which is thickened by the crosslinked layer **5** as shown in Fig. 1(e). As a result, the gap between resist patterns is narrowed and a resist pattern having a separation size or hole opening size below a limit resolution of an exposure wavelength can be formed. The pattern thus formed can be utilized as a mask for fine processing of a substrate, a resist mask for treatment of a substrate or the like, such as an etching mask or an ion implantation mask.

A resist pattern of the invention that is made fine by the crosslinked coating layer is sometimes formed on an insulating layer such as a silicon oxide film or sometimes formed on an electric conductive layer such as polysilicon film, depending on a process of manufacturing an electronic device. In this manner, the formation of a fine resist pattern that is made by the crosslinked coating layer in the invention is not restricted by a base film. The resist pattern is formed on any substrate as long as a resist pattern can be formed thereon, corresponding to the requirement.

In the invention, by use of the fine resist pattern formed as described above as a mask, semiconductor substrate base materials such as a semiconductor substrate or various thin films on the semiconductor substrate are etched, and a fine space, a fine hole, etc. are formed in the semiconductor substrate material to thereby manufacture an electronic device. Further, when a semiconductor substrate material is etched by using, as a mask, a fine pattern mask obtained by that materials constituting a photoresist, a composition thereof and/or a baking temperature during the formation of a crosslinked coating layer are appropriately set and a crosslinked layer is formed on the photoresist under such condition, an effect of roughening the side wall surface of the substrate pattern is obtained after the etching.

### Advantageous effects of the Invention

As described in detail above, a fine pattern forming material can be provided, which is excellent in stability with time and can well controllably form a crosslinked coating layer having a large thickness without increasing a temperature during crosslinking reaction by use of a fine pattern forming material of the present invention having a pH value of exceeding 7 and being formed by addition of a secondary amine compound or a tertiary amine compound to a mixture solution of a water soluble resin, a water soluble crosslinking agent and water or water and a water soluble organic solvent. Further, a fine pattern forming material can be provided, which can well controllably form a resist pattern that has few development defects and has a crosslinked coating layer having a small thickness and is formed by a fine pattern forming material of the present invention having a pH value of exceeding 7 and being formed by addition of a quaternary amine compound to a mixture solution of a water soluble resin, a water soluble crosslinking agent and water or water and a water soluble organic solvent. In addition, further inclusion of a nonionic surfactant in a fine pattern forming material can improve the application properties of the fine pattern forming material and form a crosslinked coating layer with a larger thickness. For this reason, even if a smaller amount of a fine pattern forming material is used, a uniform coating layer can be formed. At this time, if a water soluble organic solvent is contained in the fine pattern forming material, the foaming due to a nonionic surfactant can be restrained and it leads to ease of handling of the material. Further, a fine pattern forming method of the invention can well controllably form a resist pattern with a crosslinked coating layer having no development defects and a larger or smaller thickness without rendering the temperature during crosslinking reaction to be high or low. This enables the formation of a pattern having a size below the limit resolution of an exposure wavelength, in accordance with the design suited design rules, inexpensively and stably and with high accuracy and high through-put, in the microfabrication for the production of electronic devices such as semiconductors etc. and three-dimensional micro structures.

### Best Mode for Carrying Out the Invention

Hereinafter, the present invention will be more specifically described with reference to Examples, but it should be understood that the invention is not restricted by these Examples by no means.

### Example 1

### (Preparation of fine pattern forming material)

100 Weight parts of polyvinyl acetal (degree of acetylation: 12 mol%, degree of acetalization: 30 mol%), 20 weight parts of a water-soluble crosslinking agent of a urea derivative, and 4 weight parts of dimethylamine were dissolved in 1470 weight parts of a mixture solvent of purified water and isopropyl alcohol serving as a water soluble organic solvent (The mixture solvent is constituted by 5 weight parts of isopropyl alcohol and 95 weight parts of purified water.) to prepare a fine pattern forming material A (Composition A).

### (Measurement of solution pH value)

The pH value of the Composition A solution was measured by using a pH meter. The result is shown in Table 1.

### (Inspection 1 of thickness of crosslinked coating layer)

AZ KrF-17B 80 available from Clariant Corporation ("AZ" is a trade name (the same, hereinafter)) was spin coated on a bare 6-inch silicon wafer, and was baked on a direct hot plate at 180°C for 60 seconds to form a film of 0.080 µm in thickness. Further, AZ DX5240P available from Clariant Corporation was spin coated on the AZ KrF-17B 80 film, and the resulting material was baked at 90°C for 60 seconds on a direct hot plate to form a resist film of AZ DX5240P with a thickness of 0.585µm. The resist film was selectively exposed through a half-tone mask with a 248.4 nm KrF excimer laser beam, and was subjected to post-exposure bake (PEB) at 120°C for 60 seconds on a direct hot plate. Then, the resist film was paddle-developed with AZ 300MIF available from Clariant Corporation and being 2.38 weight-% aqueous tetramethylammonium hydroxide solution as a developer for 60 seconds to form a hole pattern of 0.220 µm in diameter on the silicon wafer. Composition A was spin coated on the hole pattern, and the resulting material was baked at 85°C for 70 seconds on a direct hot plate to forma filmof Composition A with a thickness of 0.350 µm. Subsequently, in order to promote a crosslinking reaction at the interface between the resist layer and the Composition A layer, baking (mixing bake) was carried out at 115°C for 70 seconds on a direct hot plate, and then, development was performed with flowing water using purified water for 60 seconds to form a coating layer. The diameter of the hole pattern after the formation of the coating layer was measured by using a CD-SEM, S9220 available from Hitachi High-Technologies Corporation. The difference between the hole diameter after the formation of the coating layer and the initial hole diameter of an AZ DX5240P resist pattern was defined as a coating layer thickness. The result is indicated in Table 1.

### (Inspection 2 of thickness of crosslinked coating layer)

This inspection 2 shows an evaluation method when an i-line resist is used as a photoresist. First, a wafer coated with a photoresist AZ 7900 available from Clariant (Japan) K.K. was prepared in the following order. That is, the photoresist was coated on a 6-inch silicon wafer processed with HMDS with a spin coater, LARC ULTIMA-1000 available from Litho Tech Japan Co., Ltd., and pre-baked at 90°C for 60 seconds on a hot plate to prepare a resist film of 1 µm in thickness. The film thickness was measured by means of a film thickness measuring apparatus, Random Ace available from Dainippon Screen MFG. Co., Ltd. Next, the resulting resist film was exposed through a reticle of a contact hole by use of a stepper having an exposure wavelength of an i-line (365 nm), LD-5015iCW (NA = 0.50) available from Hitachi Co., Ltd., and then subjected to heat treatment on a hot plate at 110°C for 90 seconds. This was paddle-developed with an alkaline developer, AZ 300MIF developer (2.38 weight-% aqueous tetramethylammonium hydroxide solution) available from Clariant (Japan) K.K. under conditions of 23°C for one minute to obtain a positive pattern of a 0.45 µm contact hole. Composition A was spin coated on the hole pattern and baked at 85°C for 70 seconds on a direct hot plate to form a film of 0.35 µm in thickness. Next, in order to promote a crosslinking reaction at the interface between the resist layer and the Composition A layer, baking (mixing bake) was carried out at 115°C for 70 seconds on a direct hot plate, and then, development was performed with flowing water of purified water for 60 seconds to form a crosslinked coating layer. The diameter of the hole pattern after formation of the crosslinked coating layer was measured by using a CD-SEM, S9220 available from Hitachi High-Technologies Corporation. The difference between the hole diameter after the formation of the coating layer and the initial hole diameter of an AZ7900resist pattern was defined as a crosslinked coating layer thickness. The result is indicated in Table 2.

### (Evaluation of application properties)

On bare 8-inch silicon wafers were flashed each 5 cc, 7.5 cc or 10 cc of Composition A and after spin coating thereof at 350 r.p.m. , the resulting materials were baked at 85°C for 70 seconds on a direct hot plate to form a film of a fine pattern forming material. And then each film thus formed was observed by eyes whether it was uniformly coated or not until the edge of the wafer. If the pattern forming material was uniformly coated until the edge of the 8-inch wafer, the evaluation mark '○' was given. If coating unevenness of the fine pattern forming material was observed on the edge of the 8-inch wafer, the evaluation mark '×' was given. In this way, the minimum coating amount of Composition A was evaluated. The results are shown in Table 3.

### Example 2

A fine pattern forming material B (Composition B) was prepared in the same manner as in Example 1 except that trimethylamine was used instead of dimethylamine. As in Example 1, "Measurement of solution pH value", "Inspection 1 of thickness of crosslinked coating layer" and "Inspection 2 of thickness of crosslinked coating layer" were carried out. The results are listed in Tables 1 and 2. In addition, as in Example 1, "Evaluation of application properties" was performed. The results are indicated in Table 3.

### Example 3

A fine pattern forming material C (Composition C) was prepared in the same manner as in Example 1 except that triethanolamine was used instead of dimethylamine. As in Example 1, "Measurement of solution pH value" and "Inspection 1 of thickness of crosslinked coating layer" were carried out. The results are indicated in Table 1.

### Example 4

A fine pattern forming material D (Composition D) was prepared in the same manner as in Example 1 except that tetramethylammonium hydroxide (TMAH) was used instead of dimethylamine. As in Example 1, "Measurement of solution pH value", "Inspection 1 of thickness of crosslinked coating layer" and "Inspection 2 of thickness of crosslinked coating layer" were carried out. The results are listed in Tables 1 and 2. In addition, as in Example 1, "Evaluation of application properties" was performed. The results are indicated in Table 3.

### Example 5

100 Weight parts of polyvinyl acetal (degree of acetylation: 12 mol%, degree of acetalization: 30 mol%), 20 weight parts of a water soluble crosslinking agent of a urea derivative, 4 weight parts of dimethylamine, and 1 weight part of Acetyrenol EL (a nonionic surfactant available from Kawaken Fine Chemicals Co., Ltd.) were dissolved in 1470 weight parts of a mixture solvent of purified water and a water soluble organic solvent, isopropyl alcohol (5 weight parts of isopropyl alcohol relative to 95 weight parts of purified water) to prepare a fine pattern forming material E (Composition E). In the same manner as in Example 1, "Measurement of solution pH value", "Inspection 1 of thickness of crosslinked coating layer" and"Inspection 2 of thickness of crosslinked coating layer" were carried out. The results are listed in Tables 1 and 2. In addition, as in Example 1, "Evaluation of application properties" was performed. The results are indicated in Table 3.

### Example 6

A fine pattern forming material F (Composition F) was prepared in the same manner as in Example 5 except that trimethylamine was used instead of dimethylamine. As in Example 1, "Measurement of Solution pH value", "Inspection 1 of thickness of crosslinked coating layer" and "Inspection 2 of thickness of crosslinked coating layer" were carried out. The results are listed in Tables 1 and 2. In addition, as in Example 1, "Evaluation of application properties" was performed. The results are indicated in Table 3.

### Example 7

A fine pattern forming material G (Composition G) was prepared in the same manner as in Example 5 except that tetramethylammonium hydroxide (TMAH) was used instead of dimethylamine. As in Example 1, "Measurement of solution pH value", "Inspection 1 of thickness of crosslinkedcoating layer" and " Inspection 2 of thickness of crosslinked coating layer" were carried out. The results are listed in Tables 1 and 2. In addition, as in Example 1, "Evaluation of application properties" was performed. The results are indicated in Table 3.

### Comparative Example 1

100 Weight parts of polyvinyl acetal (degree of acetylation: 12 mol%, degree of acetalization: 30 mol%) and 20 weight parts of a water soluble crosslinking agent of a urea derivative were dissolved in 1470 weight parts of a mixture solvent of purified water and a water soluble organic solvent, isopropyl alcohol (5 weight parts of isopropyl alcohol relative to 95 weight parts of purified water) to prepare a fine pattern forming material H (Composition H). In the same manner as in Example 1, "Measurement of solution pH value", "Inspection 1 of thickness of crosslinked coating layer" and "Inspection 2 of thickness of crosslinked coating layer" were carried out. The results are listed in Tables 1 and 2. In addition, as in Example 1, "Evaluation of application properties" was performed. The results are indicated in Table 3.

### Comparative Example 2

100 Weight parts of polyvinyl acetal (degree of acetylation: 12 mol%, degree of acetalization: 30 mol%), 20 weight parts of a water soluble crosslinking agent of a urea derivative, and 1 weight part of Acetyrenol EL (a nonionic surfactant available from Kawaken Fine Chemicals Co., Ltd.) were dissolved in 1470 weight parts of a mixture solvent of purified water and a water soluble organic solvent, isopropyl alcohol (5 weight parts of isopropyl alcohol relative to 95 weight parts of purified water) to prepare a fine pattern forming material I (Composition I). In the same manner as in Example 1, "Measurement of solution pH value", "Inspection 1 of thickness of crosslinked coating layer" and "Inspection 2 of thickness of crosslinked coating layer" were carried out. The results are listed in Tables 1 and 2. In addition, as in Example 1, "Evaluation of application properties" was performed. The results are indicated in Table 3.

**Table 1. Inspection 1 of thickness of crosslinked coating layers**

| Example | Composition | Amine Compounds | Surfactant | Coating Layer Thickness (µm) | pH value |
|---|---|---|---|---|---|
| Example 1 | A | Dimethylamine: secondary amine | Not contained | 0.082 | 8.5 |
| Example 2 | B | Trimethylamine: tertiary amine | Not contained | 0.083 | 8.6 |
| Example 3 | C | Triethanol amine: tertiary amine | Not contained | 0.106 | 8.5 |
| Example 4 | D | Tetramethylammonium hydroxide: quaternary amine | Not contained | 0.057 | 9.6 |
| Example 5 | E | Dimethylamine: secondary amine | Contained | 0.090 | 8.5 |
| Example 6 | F | Trimethylamine: tertiary amine | Contained | 0.088 | 8.6 |
| Example 7 | G | Tetramethylammonium hydroxide: quaternary amine | Contained | 0.060 | 9.6 |
| Comparative Example 1 | H | Not contained | Not contained | 0.077 | 3.8 |
| Comparative Example 2 | I | Not contained | Contained | 0.082 | 3.8 |

The results of Table 1 indicate that, when a fine pattern forming material containing therein a secondary amine compound or tertiary amine compound is applied on a pattern of a chemically amplified positive-working photoresist, the thickness of the crosslinked coating layer becomes larger than that of the crosslinked coating layer formed by use of a fine pattern forming material not containing an amine compound. More specifically, Compositions A to C are increased in the thickness of the crosslinked coating layer as compared with Composition H; and Compositions E and F are increased in the thickness of a crosslinked coating layer as compared with Composition I. Further, the results of Table 1 indicate that, when a nonionic surfactant is added to a fine pattern forming material, the thickness of the crosslinked coating layer thereof is increased as apparent from the comparisons of Composition A with Composition E, Composition B with Composition F, Composition D with Composition G, and Composition H with Composition I. In addition, it is apparent from the results of Table 1 that, when a secondary amine compound or tertiary amine compound is added, the pH values of the fine pattern forming material solutions each exceeds 7.

On the other hand, it is apparent from the comparisons of Composition D with Composition H and Composition G with Composition I that, when a quaternary amine compound is contained in a fine pattern forming material, the thickness of the crosslinked layer thereof becomes smaller than that of a crosslinked coating layer formed by use of a fine pattern forming material not containing an amine compound. That is, Compositions D and G are decreased in the thicknesses of the crosslinked coating layers as compared with Compositions H and I.

**Table 2. Inspection 2 of thickness of crosslinked coating layers**

| Example | Composition | Amine Compounds | Surfactant | Coating Layer Thickness (µm) | pH value |
|---|---|---|---|---|---|
| Example 1 | A | Dimethylamine: secondary amine | Not contained | 0.096 | 8.5 |
| Example 2 | B | Trimethylamine: tertiary amine | Not contained | 0.095 | 8.6 |
| Example 4 | D | Tetramethylammonium hydroxide: quaternary amine | Not contained | 0.059 | 9.6 |
| Example 5 | E | Dimethylamine: secondary amine | Contained | 0.111 | 8.5 |
| Example 6 | F | Trimethylamine: tertiary amine | Contained | 0.110 | 8.6 |
| Example 7 | G | Tetramethylammonium hydroxide: quaternary amine | Contained | 0.068 | 9.6 |
| Comparative Example 1 | H | Not contained | Not contained | 0.081 | 3.8 |
| Comparative Example 2 | I | Not contained | Contained | 0.095 | 3.8 |

It is apparent from Table 2 that, even on an i-line photoresist pattern, the thickness of the crosslinked coating layer becomes larger than that of the crosslinked coating layer formed by use of a fine pattern forming material not containing an amine compound when a fine pattern forming material contains therein a secondary amine compound or tertiary amine compound. That is, Compositions A and B are increased in the thickness of the crosslinked coating layer as compared with Composition H; and Compositions E and F are increased in the thickness of the crosslinked coating layer as compared with Composition I.

On the other hand, it is apparent from the comparisons of Composition D with Composition H and Composition G with Composition I that, when a quaternary amine compound is contained in a fine pattern formingmaterial, the thickness of the crosslinked layer becomes smaller than that of the crosslinked coating layer formed by use of a fine pattern forming material not containing an amine compound. That is, the thicknesses of the crosslinked coating layers of Compositions D and G are decreased when compared with those of Compositions H and I.

**Table 3. Evaluation of application properties**

| Example | Composition | Amine Compounds | Surfactant | Amounts of composition applied (cc) | | |
|---|---|---|---|---|---|---|
| | | | | 5 | 7.5 | 10 |
| Example 1 | A | Dimethylamine: secondary amine | Not contained | × | ○ | ○ |
| Example 2 | B | Trimethylamine: tertiary amine | Not contained | × | ○ | ○ |
| Example 4 | D | TMAH: quaternary amine | Not contained | × | ○ | ○ |
| Example 5 | E | Dimethylamine: secondary amine | Contained | ○ | ○ | ○ |
| Example 6 | F | Trimethylamine: tertiary amine | Contained | ○ | ○ | ○ |
| Example 7 | G | TMAH: quaternary amine | Contained | ○ | ○ | ○ |
| Comparative Example 1 | H | Not contained | Not contained | × | ○ | ○ |
| Comparative Example 2 | I | Not contained | Contained | ○ | ○ | ○ |

From the results of Table 3, the all surface area of 8-inch wafer could be uniformly coated with Composition E, F, G or I each containing a surfactant therein in an application amount of 5 cc, while not all surface area of 8-inch wafer could be uniformly coated with Composition A, B, D or H each containing no surfactant therein in an application amount of 5 cc.

As described so far, it has been confirmed from the results of Tables 1 to 3 that the thickness of a crosslinked coating layer increases by the addition of a secondary amine compound or tertiary amine compound to a fine pattern forming material and the addition of a surfactant thereto improves the application properties. Further, it has been confirmed that the thickness of a crosslinked coating layer is also increased by addition of a surfactant. Furthermore, it is confirmed that addition of a quaternary amine compound decreases the thickness of a crosslinked coating layer.

## Claims

1. A fine pattern forming material that is applied onto a resist pattern, causes a crosslinking reaction by heat treatment, and then subj ected to development processing to form a crosslinked coating layer on the resist pattern, wherein water or a mixture liquid of water and a water soluble organic solvent is used as a solvent, the fine pattern forming material is formed by adding a water soluble resin, a water soluble crosslinking agent and an amine compound into the solvent, an increase or decrease in the thickness of the crosslinked coating layer, thereby, can be controlled as compared with a crosslinked coating layer formed by use of a fine pattern forming material prior to the addition of the amine compound, and a pH value of the resulting solution exceeds 7.

2. A fine pattern forming material that is applied onto a resist pattern, causes a crosslinking reaction by heat treatment, and then subj ected to development processing to form a crosslinked coating layer on the resist pattern, wherein water or a mixture liquid of water and a water soluble organic solvent is used as a solvent, the fine pattern forming material is formed by adding a water soluble resin, a water soluble crosslinking agent and a secondary amine compound and/or tertiary amine compound into the solvent, a thickness of the crosslinked coating layer, thereby, increases as compared with a crosslinked coating layer formed by use of a fine pattern forming material prior to the addition of the amine compound, and a pH value of the resulting solution exceeds 7.

3. The fine pattern forming material according to claim 2, wherein the secondary amine compound is a compound selected from dimethylamine, diethylamine, dimethanolamine and diethanolamine, and the tertiary amine compound is a compound selected from trimethylamine, triethylamine, trimethanolamine and triethanolamine.

4. A fine pattern forming material that is applied onto a resist pattern to cause a crosslinking reaction by heat treatment and then subjected to development processing to form a crosslinked coating layer on the aforementioned resist pattern, wherein water or a mixture liquid of water and a water soluble organic solvent is used as a solvent, the fine pattern forming material is formed by adding a water soluble resin, a water soluble crosslinking agent and a quaternary amine compound into the solvent, a thickness of the crosslinked coating layer, thereby, decreases as compared with a crosslinked coating layer formed by use of a fine pattern forming material prior to the addition of the amine compound, and a pH value of the resulting solution exceeds 7.

5. The fine pattern forming material according to claim 4, wherein the quaternary amine compound is a compound selected from tetramethylammonium hydroxide, tetraethylammonium hydroxide, tetramethylammonium chloride, and tetraethylammonium chloride.

6. The fine pattern forming material according to any one of claims 1 to 5, wherein the water soluble resin is a polyvinyl alcohol derivative, and the water soluble resin is at least one selected from the group consisting of melamine derivatives and urea derivatives.

7. The fine pattern forming material according to claim 6, wherein the polyvinyl alcohol derivative does not contain therein a vinyl acetate residue causing a deacetylation reaction.

8. The fine pattern forming material according to any one of claims 1 to 7, further comprising a nonionic surfactant, and thereby improving the application properties.

9. The fine pattern forming material according to claim 8, wherein the nonionic surfactant is at least one selected from polyoxyethyleneoctyl ether, polyoxyethylenelauryl ether and polyoxyethyleneacetylenic glycol ether.

10. A method of forming a fine resist pattern, comprising the steps of:
applying a photoresist on a substrate and then forming a photoresist pattern,
applying the fine pattern forming material described in any one of claims 1 to 9 onto the photoresist pattern to form a coating layer,
baking the photoresist pattern and the coating layer, and
developing the coating layer.

11. An electronic device manufactured by the method of forming a fine resist pattern described in claim 10.
